# EUROPÄISCHE PATENTSCHRIFT

(11) **EP 2 624 378 B1**
(45) Veröffentlichungstag und Bekanntmachung des Hinweises auf die Patenterteilung: **04.03.2015**
(21) Anmeldenummer: 12153252.7
(22) Anmeldetag: 31.01.2012
(51) Int. Cl.: H01R 31/08, H05K 7/14, H01R 107/00

(54) **Ein-/Ausgabebaugruppe der industriellen Automatisierungstechnik**
Input/output assembly for industrial automation technology
Module d'entrée/sortie pour l'automatisation industrielle

(43) Veröffentlichungstag der Anmeldung: 07.08.2013
(73) Patentinhaber: Siemens Aktiengesellschaft, 80333 München (DE)
(72) Erfinder: Donhauser, Peter, 92224 Amberg (DE); Drehmann, Gennadij, 90491 Nürnberg (DE)

(56) Entgegenhaltungen:
- EP-A1- 0 190 308
- DE-A1- 19 514 842

## Beschreibung

Die Erfindung betrifft eine Ein-/Ausgabebaugruppe der industriellen Automatisierungstechnik, umfassend ein Basisteil mit einer Forderseite und einer Rückseite, eine Flachbaugruppe, eine an der Forderseite angeordnete Kontaktleiste mit einer Mehrzahl von Kontaktelementen dazu ausgestaltet mit entsprechenden Gegenkontaktelementen einer Steckerleiste eine elektrische Verbindung einzugehen.

Derartige Ein-/Ausgabebaugruppen sind aus der DE 195 14 842 B4 bekannt.

Ein-/Ausgabebaugruppen werden in der industriellen Automatisierungstechnik als beispielsweise analoge- und digitale Peripheriebaugruppen eingesetzt. Bei den digital-analog Ein-/Ausgabebaugruppen werden über die Steckerleiste bzw. einen sogenannten Frontstecker elektrische Signale aus einem Automatisierungsprozess an die Ein-/Ausgabebaugruppe herangeführt. Die in der Ein-/Ausgabebaugruppe enthaltene Flachbaugruppe weist dabei eine elektronische Schaltung auf, welche für den jeweiligen Anwendungsfall konzipiert ist und somit beispielsweise Regelungsaufgaben, Steuerungsaufgaben, Ein-Ausgabeweiterleitungen von Prozesssignalen usw. ausführt. Bei beispielsweise einer digitalen Ein-/Ausgabebaugruppe müssen zusätzlich zu den Signalleitungen Potentialleitungen zur Versorgung mit einer Versorgungsspannung an die Flachbaugruppe herangeführt werden. In der Regel werden jeweils acht Signalleitungen mit zwei Potentialleitungen versorgt. Bei einer beispielsweise 32-kanaligen Baugruppe müssen demnach für die 4-mal 8 Signalleitungen auch 4-mal 2 Potentialleitungen angeschlossen werden. Bei den nach dem Stand der Technik bekannten 32-kanaligen Baugruppen ist es deshalb erforderlich, für die 4-mal 8 Signalleitungen, auch 4-mal 2 Potentialleitungen anzuschließen. Demnach ist es bei dem Stand der Technik von Nachteil, dass an der Steckerleiste bzw. an dem Frontstecker eine unerwünscht hohe Anzahl von Potentialleitungen angeklemmt werden muss.

Es ist daher die Aufgabe der vorliegenden Erfindung eine Ein-/Ausgabebaugruppe der industriellen Automatisierungstechnik bereitzustellen, welche es ermöglicht, die Anzahl von anzuschließenden Potentialleitungen an die Steckerleiste zu reduzieren.

Die Aufgabe wird für die eingangs genannte Ein-/Ausgabebaugruppe dadurch gelöst, dass ein Mittel zur Weiterleitung einer Versorgungsspannung für die Flachbaugruppe parallel zu der Kontaktleiste angeordnet ist, wobei das Mittel eine Klemmstelle aufweist und die Steckerleiste derart ausgestaltet ist, dass sie eine Mehrzahl an Gegenklemmstellen aufweist, welche mit den jeweiligen Gegenkontaktelementen in elektrischer Verbindung stehen, wobei über ein in die Klemmstelle und in die Gegenklemmstelle einsteckbares Brückenelement die Versorgungsspannung an die Flachbaugruppe angeschaltet wird. Mit Vorteil kann nun über das Mittel zur Weiterleitung der Versorgungsspannung eine Versorgungsspannung über die Klemmstellen und die Gegenklemmstelle bei gestecktem Brückenelement die Versorgungsspannung an die Flachbaugruppe herangeführt werden ohne dass eine zusätzliche Verdrahtung von Potentialleitungen in der Steckerleiste notwendig ist.

In einer vorteilhaften Ausgestaltung der Ein-/Ausgabebaugruppe ist das Mittel von einem Isolierkörper umgeben und derart im Bereich der Vorderseite angeordnet, dass bei einer von der Vorderseite auf die Kontaktleiste aufgesteckten Steckerleiste der Isolierkörper zwischen der Kontaktleiste und der Steckerleiste angeordnet ist.

In einer weiteren Ausgestaltung ist das Mittel als ein sich in einer Längsrichtung erstreckendes Leiterpaar mit einem ersten Leiter und einem zweiten Leiter ausgestaltet. Da bei dieser Ausgestaltungsvariante der erste Leiter und der zweite Leiter längs in der Kontaktleiste angeordnet ist, können an beliebigen Stellen des ersten Leiters und des zweiten Leiters Klemmstellen an dem ersten Leiter und den zweiten Leiter angeordnet sein und somit an beliebigen Stellen mittels des Brückenelementes eine Versorgungsspannung über die entsprechenden Gegenkontaktelemente an die Flachbaugruppe über die Kontaktelemente weitergegeben werden ohne dass eine zusätzliche Verdrahtung mit Potentialleitungen notwendig ist.

Demnach ist es vorteilhaft, dass das Mittel eine erste Klemmstelle und eine zweite Klemmstelle aufweist, welche bezogen auf die Längsrichtung hintereinander angeordnet sind.

In einer weiteren vorteilhaften Ausgestaltung ist die Kontaktleiste als eine erste Kontaktleiste und eine zweite Kontaktleiste ausgestaltet und in der Längsrichtung sind die Kontaktelemente als eine erste Kontaktreihe der ersten Kontaktleiste und als eine zweite Kontaktreihe der zweiten Kontaktleiste hintereinander angeordnet.

Weiterhin ist es von Vorteil, wenn der Isolierkörper eine erste Aufnahme für die erste Klemmstelle und eine zweite Aufnahme für die zweite Klemmstelle aufweist.

Um das Einspeisen bzw. das Anlegen einer Versorgungsspannung an die Kontaktelemente möglichst benutzerfreundlich zu gestalten, ist die Ein-/Ausgabebaugruppe mit dem Mittel zur Weiterleitung der Versorgungsspannung derart ausgestaltet, dass die hintereinander angeordneten Klemmstellen zwischen der ersten Kontaktreihe und der zweiten Kontaktreihe derart angeordnet sind, dass ein eingestecktes erstes Brückenelement die erste Klemmstelle mit einer ersten Gegenklemmstelle und mit einer zweiten Gegenklemmstelle elektrisch verbindet, wobei die erste Gegenklemmstelle in der ersten Kontaktreihe angeordnet ist und die zweite Gegenklemmstelle in der zweiten Kontaktreihe angeordnet ist und ein eingestecktes zweites Brückenelement die zweite Klemmstelle mit einer dritten Gegenklemmstelle und mit einer vierten Gegenklemmstelle elektrisch verbindet, wobei die dritte Gegenklemmstelle in der ersten Kontaktreihe angeordnet ist und die vierte Gegenklemmstelle in der zweiten Kontaktreihe angeordnet ist.

Für eine Ausgestaltung einer Ein-/Ausgabebaugruppe mit einer Steckerleiste, welche eine erste Kontaktreihe und eine zweite Kontaktreihe aufweist, wobei die erste Kontaktreihe zu einer ersten Flachbaugruppe zugeordnet ist und die zweite Kontaktreihe zu einer zweiten Flachbaugruppe zugeordnet ist muss nicht immer so sein, wobei die Flachbaugruppen ähnlich wie eingesteckte elektronische Leiterplatten linksseitig bzw. rechtsseitig in dem Basisteil, welches beispielsweise ein Gehäuse bildet, angeordnet sind, ist folgende Anordnung denkbar. Die erste Klemmstelle des Mittels zur Weiterleitung der Versorgungsspannung steht mit dem ersten elektrischen Leiter, welcher beispielsweise an eine Plus-Leitung angeschlossen ist, in Verbindung und die zweite Klemmstelle des mittels zur Weiterleitung der Versorgungsspannung steht mit dem zweiten Leiter in elektrischer Verbindung, wobei der zweite Leiter beispielsweise an eine Minus-Leitung angeschlossen ist. Durch die zuvor genannte Anordnung der ersten Gegenklemmstelle in der ersten Kontaktreihe und der zweiten Gegenkontaktstelle in der zweiten Kontaktreihe, kann durch ein eingestecktes Brückenelement zum Einen die linksseitig angeordnete Flachbaugruppe bzw. Leiterplatte mit der Plus-Versorgungsspannung und zum Anderen die rechtsseitig angeordnete Flachbaugruppe bzw. Leiterplatte mit derselben Plus-Versorgungsspannung versorgt werden. Eine analoge links- und rechtsseitige Versorgung der Leiterplatten mit der Minus-Versorgungsspannung ist durch diesen Aufbau ebenfalls gegeben.

Bei einer weiter optimierten Ausgestaltung weist die Steckerleiste Öffnungen zum Einstecken der Brückenelemente auf. Mit den Öffnungen, welche beispielsweise in dem Isolierkörper angeordnet sind, kann ein baugruppenspezifisches Raster zum Einstecken von Brückenelementen für eine jeweilige Baugruppe, mit beispielsweise einer besonderen Technologie, vorgegeben werden. Es ist dadurch möglich nur an bestimmter Stelle die Versorgungsspannung mittels der Brückenelemente anzuschalten.

Weiterhin ist es von Vorteil, wenn die Steckerleiste an der Vorderseite schwenkbar mit dem Basisteil verbunden ist, wodurch die Steckerleiste mittels einer Schwenkbewegung auf die Kontaktleiste aufsetzbar ist.

Um das Anschließen einer Versorgungsspannung an das Mittel zur Weiterleitung der Versorgungsspannung zu erleichtern, weist der erste Leiter einen ersten Einspeisekontakt und der zweite Leiter einen zweiten Einspeisekontakt auf, welche mit einer Einspeiseklemme verbunden sind.

In einer vorteilhaften Ausgestaltung ist die Einspeiseklemme derart an der Steckerleiste angeordnet, dass sie nach der Schwenkbewegung auf die Kontaktleiste mit dem ersten Einspeisekontakt und dem zweiten Einspeisekontakt kontaktiert und somit die Versorgungsspannung, welche über einen Minus-Leiter und einem Plus-Leiter, welche an der Einspeiseklemme angeschlossen sind, an den ersten und den zweiten Leiter angeschaltet ist. An der Einspeiseklemme, welches vorteilhafter Weise mechanisch mit der Steckerleiste verrastet ist, können demnach vorteilhafter Weise zwei Potentialleitungen, beispielsweise 1-mal Minus und 1-mal Plus angeschlossen sein. Durch das Einschwenken der Steckerleiste, welche vorteilhafter Weise als ein Frontstecker ausgebildet ist, auf die Ein-/Ausgabebaugruppe bzw. auf die Kontaktleiste, wird die Einspeiseklemme mit den Einspeisekontakten kontaktieret, wobei ebenfalls die Kontaktelemente der Kontaktleiste mit den Gegenkontaktelementen der Steckerleiste kontaktieren.

Um eine Vielzahl von technologischen Funktionen auf der Flachbaugruppe unterzubringen ist die Flachbaugruppe als eine erste Leiterplatte und eine zweite Leiterplatte ausgestaltet und die erste und/oder zweite Leiterplatte weisen dabei mehrere Funktionsmodule auf, wobei die Funktionsmodule über das Mittel zur Weiterleitung der Versorgungsspannung jeweils mit der Versorgungsspannung versorgt werden und für jedes Funktionsmodul je zwei Klemmstellen in dem Mittel vorgesehen sind.

Bei der Ein-/Ausgabebaugruppe mit dem eingesteckten Brückenelement ist es vorteilhaft, dass das Brückenelement einen ersten Schenkel, einen zweiten Schenkel und einen dritten Schenkel aufweist, und der erste und der zweite Schenkel annähernd von gleicher Länge und gabelförmig zueinander angeordnet sind, der dritte Schenkel ist an einem Gabelpunkt des ersten und zweiten Schenkels angeordnet und weist eine Länge auf, welche die Länge des ersten und zweiten Schenkels überragt. Mit Vorteil ist der dritte Schenkel gegenüber dem ersten Schenkel und dem zweiten Schenkel demnach voreilend ausgestaltet, dass bedeutet die in dem Mittel angeordnete Klemmstelle, welche unterhalb der Steckerleiste angeordnet ist, kann somit durch den voreilenden dritten Schenkel vom Brückenelemente kontaktiert werden.

Ein Ausführungsbeispiel wird in der Zeichnung erläutert. Es zeigen:
- FIG 1: eine Ein-/Ausgabebaugruppe in einer perspektivischen Darstellung,
- FIG 2: die Ein-/Ausgabebaugruppe mit aufgeschnittenem Gehäuse,
- FIG 3: ein Mittel zur Weiterleitung einer Versorgungsspannung,
- FIG 4: ein metallisches Kontaktelement, welches neben einer Mehrzahl von weiteren Kontaktelementen innerhalb einer Steckerleiste angeordnet ist,
- FIG 5: die Ein-/Ausgabebaugruppe in einer detaillierten Ansicht und
- FIG 6: ein Brückenelement.

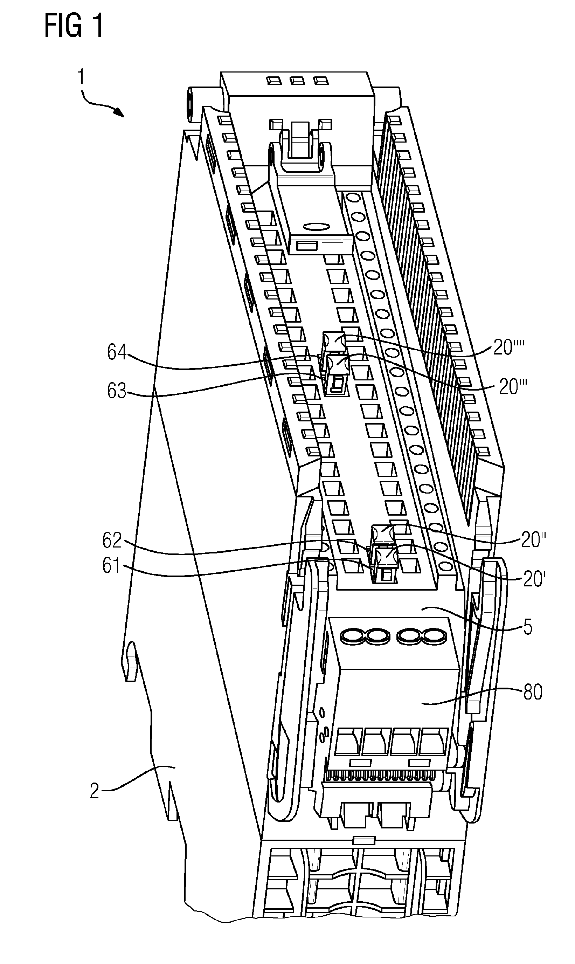

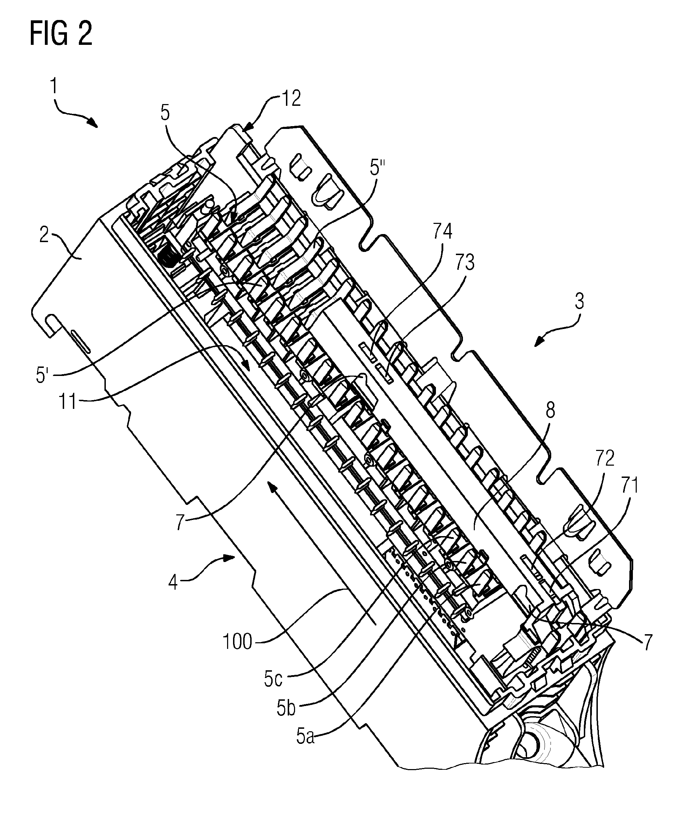

Gemäß der FIG 1 ist eine Ein-/Ausgabebaugruppe 1 für die industrielle Automatisierung dargestellt. Die Ein-/Ausgabebaugruppe 1 umfasst ein Basisteil 2 mit einer Vorderseite 3 und einer Rückseite 4, siehe hierzu auch die FIG 2, in welcher die Ein-/Ausgabebaugruppe 1 in einer aufgeschnittenen perspektivischen Darstellung abgebildet ist.

Die Ein-/Ausgabebaugruppe 1 wird vorzugsweise in der Automatisierungstechnik als eine Schnittstelle zwischen einer Automatisierungssteuerung und einem zu automatisierenden Prozess eingesetzt, dabei ist die Ein-/Ausgabebaugruppe 1 in der Regel über ein Bussystem, beispielsweise über einen Rückwandbus, an der Rückseite 4, mit einer übergeordneten Automatisierungssteuerung verbunden, wobei an eine auf die Ein-/Ausgabebaugruppe 1 aufsteckbare Steckerleiste Signalleitungen angeklemmt werden können. Die Signalleitungen sind mit beispielsweise Sensoren oder Aktoren in dem zu automatisierenden Prozess verbunden.

An der Rückseite 4 ist eine Aussparung ausgestaltet, mit welcher die Ein-/Ausgabebaugruppe 1 auf eine Profilschiene gerastet werden kann und dabei mit dem Rückwandbus kontaktiert.

Gemäß FIG 2 befinden sich in den Seitenteilen der Ein-/Ausgabebaugruppe 1 eine erste Flachbaugruppe 11 und eine zweite Flachbaugruppe 12, welche eine erste Leiterplatte und eine zweite Leiterplatte darstellen, zwischen diesen beiden Leiterplatten 11,12 ist die Kontaktleiste 5 mit einer Vielzahl von Kontaktelementen 5a,5b,5c usw. angeordnet. Die Kontaktleiste 5 gliedert sich in eine erste Kontaktleiste 5' und in eine zweite Kontaktleiste 5", wobei die erste Kontaktleiste 5' der ersten Flachbaugruppe 11 und die zweite Kontaktbaugruppe 5" der zweiten Flachbaugruppe 12 zugeordnet ist.

Die zuvor genannte Anordnung der Kontaktleisten ist keinesfalls als eine Einschränkung zu verstehen, es könnten als Ausgestaltungsvarianten folgende Fälle gewählt werden.
- Fall 1:: Die Ein-/Ausgabebaugruppe umfasst zwei bestückte Leiterplatten, wobei jede Leiterplatte eine Messerleiste bzw. Kontaktleiste trägt.
- Fall 2:: Die Ein-/Ausgabebaugruppe umfasst zwei bestückte Leiterplatten, wobei nur eine Leiterplatte eine doppelte Messerleiste bzw. Kontaktleiste trägt.
- Fall 3:: Die Ein-/Ausgabebaugruppe umfasst zwei bestückte Leiterplatten wobei nur eine Leiterplatte eine einreihige Messerleiste bzw. Kontaktleiste trägt.

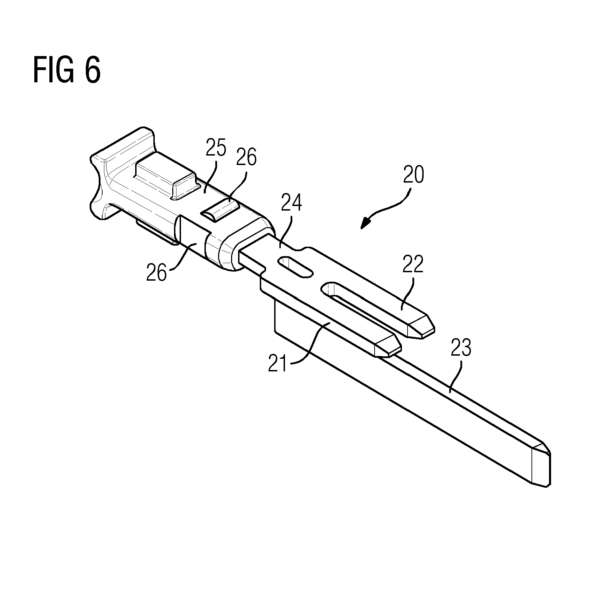

Ein Mittel 7 zur Weiterleitung einer Versorgungsspannung für die Flachbaugruppen 11,12 ist parallel zu der Kontaktleiste 5 angeordnet, wobei das Mittel 7 eine erste Klemmstelle 71, eine zweite Klemmstelle 72, eine dritte Klemmstelle 73 und eine vierte Klemmstelle 74 aufweist. In die erste bis vierte Klemmstelle 71,...,74 können später entsprechend steckbare Brückenelemente 20 (siehe FIG 6) zur Anschaltung der Versorgungsspannung an die Flachbaugruppe gesteckt werden.

Gemäß FIG 1 weist die Kontaktleiste 5 eine Umhausung auf, welche mit entsprechenden Öffnungen 61,62,63 und 64 zum Einstecken von Brückenelementen 20 ausgestaltet ist. Die Anzahl der Öffnungen ist prinzipiell nicht auf vier beschränkt, es könnten beispielsweise auch zwanzig Öffnungen vorgesehen werden.

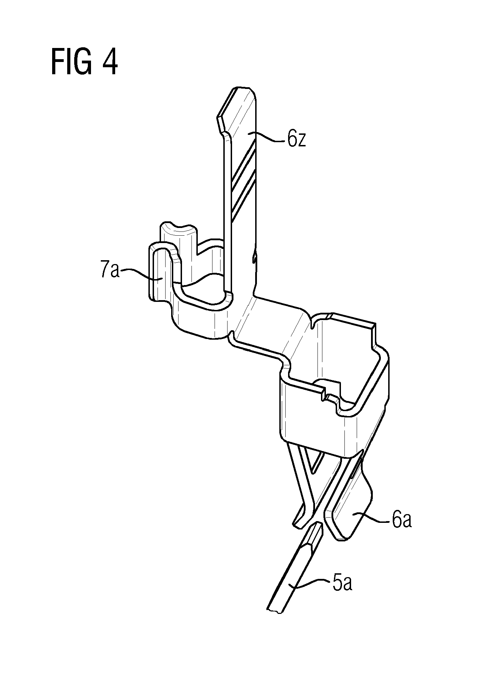

Nach dem Beispiel gemäß FIG 1 sind ein erstes Brückenelement 20', ein zweites Brückenelement 20", ein drittes Brückenelement 20'" und ein viertes Brückenelement 20"" gesteckt. Die Brückenelemente 20',...,20"" durchdringen die Umhausung der Steckerleiste 5 und kontaktieren über Kontaktelemente, wie sie in FIG 4 dargestellt sind, das Mittel zur Weiterleitung der Versorgungsspannung.

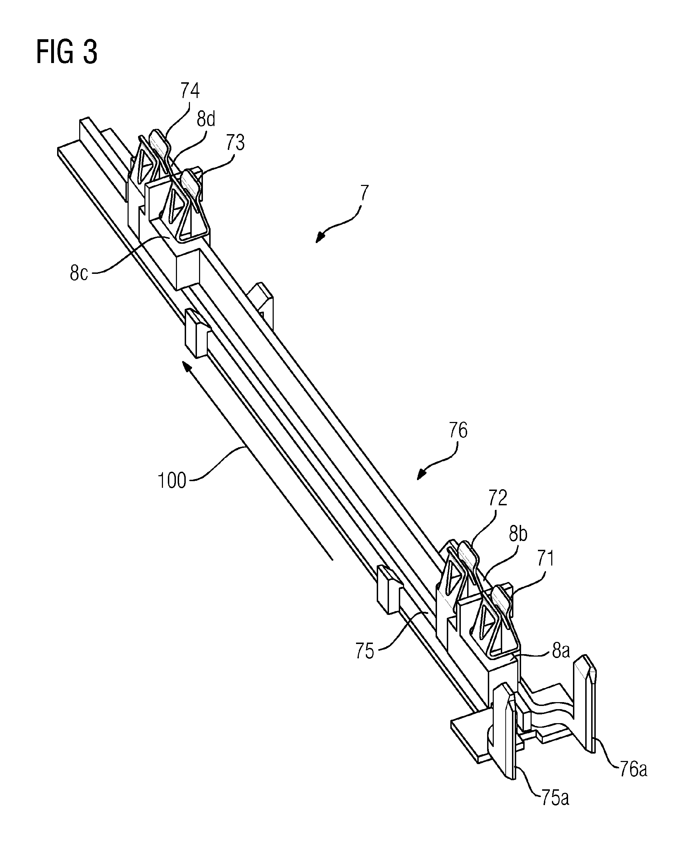

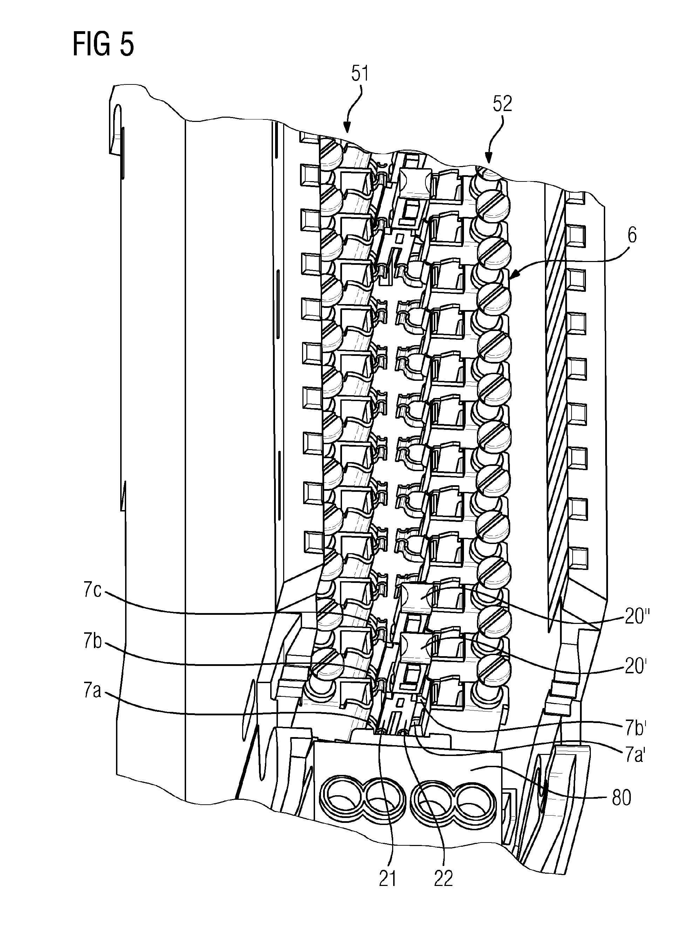

Eine genauere Ansicht der Kontaktierung bietet FIG 5, hier ist das erste Brückenelement 20' derart in die Kontaktleiste 5 eingesteckt, dass ein erster Schenkel 21 mit einer ersten Gegenklemmstelle 7a kontaktiert und ein zweiter Schenkel 22 mit einer zweiten Gegenklemmstelle 7a' kontaktiert. Ein dritter Schenkel 23 kontaktiert dabei die erste Klemmstelle 71 (siehe FIG 3).

Zum Aufbau des Brückenelementes 20 siehe FIG 6. FIG 6 zeigt das Brückenelement 20 mit einem ersten Schenkel 21 und einem zweiten Schenkel 22 und einem dritten Schenkel 23. Wobei der erste Schenkel 21 und der zweite Schenkel 22 annähernd von gleicher Länge und gabelförmig zueinander angeordnet sind, der dritte Schenkel 23 ist an einen Gabelpunkt 24 des ersten und zweiten Schenkels 21,22 angeordnet und weist eine Länge auf, welche die Länge des ersten und zweiten Schenkels 21,22 überragt. Die Schenkel 21,22 und 23 münden in einen Griff 25, welcher zusätzliche Verrastnasen 26 aufweist.

Wie in FIG 5 dargestellt, unterteilt sich die Kontaktleiste 5 in eine erste Kontaktreihe 51 und eine zweite Kontaktreihe 52, wobei die erste Klemmstelle 71 und die zweite Klemmstelle 72 gemäß FIG 2 hintereinander angeordnet sind und derart in der ersten Kontaktreihe 51 und der zweiten Kontaktreihe 52 angeordnet sind, dass das eingesteckte erste Brückenelement 20' die erste Klemmstelle 71 mit einer ersten Gegenklemmstelle 7a und mit einer zweiten Gegenklemmstelle 7a' elektrisch verbindet, wobei die erste Gegenklemmstelle 7a in der ersten Kontaktreihe 51 angeordnet ist und die zweite Gegenklemmstelle 7a' in der zweiten Kontaktreihe 52 angeordnet ist und ein weiteres eingestecktes zweites Brückenelement 22' die zweite Klemmstelle 72 mit einer dritten Gegenklemmstelle 7b und mit einer vierten Gegenklemmstelle 7b' elektrisch verbindet, wobei die dritte Gegenklemmstelle 7b in der ersten Kontaktreihe 51 angeordnet ist und die vierte Gegenklemmstelle 7b' in der zweiten Kontaktreihe 52 angeordnet ist.

Zur besseren Verständlichkeit der Durchkontaktierung einer Versorgungsspannung wird auf FIG 3 verwiesen.

Gemäß FIG 3 ist ein Mittel 7 zur Weiterleitung der Versorgungsspannung dargestellt. Das Mittel 7 erstreckt sich in einer Längsrichtung 100 mit einem ersten Leiter 75 und einem zweiten Leiter 76. Der erste Leiter 75 und der zweite Leiter 76 sind derart in ein Kunststoffspritzgussteil eingebettet, dass sie gegeneinander isoliert sind. Die erste Klemmstelle 71 steht mit dem ersten Leiter 75 in elektrischer Verbindung und die zweite Klemmstelle 72 steht mit dem zweiten Leiter 76 in elektrischer Verbindung. Analog dazu sind die dritte Klemmstelle 73 und die vierte Klemmstelle 74 ebenfalls mit dem ersten Leiter 75 bzw. dem zweiten Leiter 76 verbunden und durch das Kunststoffteil voneinander elektrisch isoliert. Das Kunststoffteil weist zur besseren Festigkeit der ersten Klemmstelle 71 bis zur vierten Klemmstelle 74 eine erste Aufnahme 8a, eine zweite Aufnahme 8b, eine dritte Aufnahme 8c und eine vierte Aufnahme 8d auf. In diesen Aufnahmen 8a,...,8d sind die Klemmstellen 70,...,74 gesichert.

Das zuvor beschriebene Mittel 7 zur Weiterleitung der Versorgungsspannung gemäß FIG 3 muss man sich bei Betrachtung der FIG 5 unterhalb der ersten Kontaktreihe 51 und der zweiten Kontaktreihe 52 angeordnet vorstellen, denn wenn das erste Brückenelement 20' eingesteckt ist kontaktiert der dritte Schenkel 23 des Brückenelementes, welcher wesentlich länger ausgestaltet ist, die erste Klemmstelle 71 des mittels 7 zur Weiterleitung der Versorgungsspannung und kann somit eine an einen ersten Einspeisekontakt 75a angelegte positive Versorgungsspannung bzw. den durch die Spannung hervorgerufenen Strom über den dritten Schenkel 23 in den ersten Schenkel 21 und in den zweiten Schenkel 22 weiterleiten und somit letztendlich über die Gegenklemmstellen 7a,7b über die Gegenkontaktelemente 6a,6b der Steckerleiste 6 an ein Kontaktelement 5a,5b (siehe hierzu FIG 4) weitergeben. Da die Kontaktelemente 5a,5b mit den linksseitig bzw. rechtsseitig in der Ein-/Ausgabebaugruppe 1 angeordneten Leiterplatten verbunden ist, wird die Versorgungsspannung an die Leiterplatten 11,12 weitergegeben.

Die bereits erwähnten Signalleitungen, welche in einen zu automatisierenden Prozess zu Aktoren oder Sensoren führen können mit Schraubklemmenverbindungen, wie sie in FIG 5 angedeutet sind, an die Steckerleiste angeklemmt werden.

Gemäß FIG 1 weist die Ein-/Ausgabebaugruppe 1 eine Einspeiseklemme 80 auf, an welche beispielsweise ein Plus-Leiter und ein Minus-Leiter zur Einspeisung einer Versorgungsspannung angeschlossen werden können.

Ist nun eine Steckerleiste an der Vorderseite 3 schwenkbar mit dem Basisteil 2 verbunden, so ist die Steckerleiste mittels einer Schwenkbewegung auf die Kontaktleiste aufsetzbar und auch eine an die Einspeiseklemme 80 angeschlossene Plus-Leitung bzw. Minus-Leitung würde durch Aufsetzen der Einspeiseklemme auf den ersten Einspeisekontakt 75a und auf den zweiten Einspeisekontakt 76a die Versorgungsspannung an das Mittel 7 zur Weiterleitung der Versorgungsspannung anschalten. Mit Vorteil steht nun innerhalb der Kontaktleiste 5 ein "Versorgungsspannungsbus" zur Verfügung. Es ist nun nicht mehr erforderlich mehrere Potentialleitungen in die Steckerleiste hineinzuführen und diese auch zu verschalten. Mit Vorteil kann nun beispielsweise eine 32-kanalige Ein-/Ausgabebaugruppe mit zwei Potentialleitungen, nämlich 1-mal Minus und 1-mal Plus versorgt werden. Nach dem Stand der Technik waren hierzu acht Potentialleitungen notwendig.

## Patentansprüche

1. Ein-/Ausgabebaugruppe (1) der industriellen Automatisierungstechnik, umfassend
- ein Basisteil (2) mit einer Vorderseite (3) und einer Rückseite (4),
- eine Flachbaugruppe (11,12),
- eine an der Vorderseite (3) angeordnete Kontaktleiste (5) mit einer Mehrzahl von Kontaktelementen (5a,5b,...) dazu ausgestaltet mit entsprechenden Gegenkontaktelementen (6a,6b) einer Steckerleiste (6) eine elektrische Verbindung einzugehen,
wobei die Kontaktelemente (5a,5b,...) mit der Flachbaugruppe (11,12) elektrisch verbunden sind,
**dadurch gekennzeichnet, dass** ein Mittel (7) zur Weiterleitung einer Versorgungsspannung für die Flachbaugruppe (11,12) parallel zu der Kontaktleiste (5) angeordnet ist, wobei das Mittel(7) eine Klemmstelle (71,...,74) aufweist und die Steckerleiste (6) derart ausgestaltet ist, dass sie eine Mehrzahl an Gegenklemmstellen (7a,7b) aufweist, welche mit den jeweiligen Gegenkontaktelementen (6a,6b) in elektrischer Verbindung stehen, wobei über ein in die Klemmstelle (71,...,74) und in die Gegenklemmstelle (7a, 7b,...) einsteckbares Brückenelement (20) die Versorgungsspannung an die Flachbaugruppe (11,12) angeschaltet wird.

2. Ein-/Ausgabebaugruppe (1) nach Anspruch 1, wobei das Mittel (7) von einem Isolierkörper umgeben ist und derart im Bereich der Vorderseite (3) angeordnet ist, dass bei einer von der Vorderseite (3) auf die Kontaktleiste (5) aufgesteckten Steckerleiste (6) der Isolierkörper zwischen der Kontaktleiste (5) und der Steckerleiste (6) angeordnet ist.

3. Ein-/Ausgabebaugruppe (1) nach Anspruch 1 oder 2, wobei das Mittel (7) als ein sich in einer Längsrichtung (100) erstreckendes Leiterpaar mit einem ersten Leiter (75) und einem zweiten Leiter (76) ausgestaltet ist.

4. Ein-/Ausgabebaugruppe (1) nach Anspruch 3, wobei das Mittel (7) eine erste Klemmstelle (71) und eine zweite Klemmstelle (72) aufweist, welche bezogen auf die Längsrichtung (100) hintereinander angeordnet sind.

5. Ein-/Ausgabebaugruppe (1) nach einem der Ansprüche 1 bis 4, wobei die Kontaktleiste (5) als eine erste Kontaktleiste (5') und eine zweite Kontaktleiste (5") ausgestaltet ist und in der Längsrichtung (100) die Kontaktelemente (5a, 5b,...) als eine erste Kontaktreihe (51) der ersten Kontaktleiste (5') und als eine zweite Kontaktreihe (52) der zweiten Kontaktleiste (5") hintereinander angeordnet sind.

6. Ein-/Ausgabebaugruppe (1) nach einem der Ansprüche 1 bis 5, wobei der Isolierkörper (8) eine erste Aufnahme (8a) für die erste Klemmstelle (71) und eine zweite Aufnahme (8b) für die zweite Klemmstelle (72) aufweist.

7. Ein-/Ausgabebaugruppe (1) nach einem der Ansprüche 5 bis 6, wobei die hintereinander angeordneten Klemmstellen (71,72) zwischen der ersten Kontaktreihe (51) und der zweiten Kontaktreihe (52) derart angeordnet sind, das
ein eingestecktes erstes Brückenelement (20')
- die erste Klemmstelle (71) mit einer ersten Gegenklemmstelle (7a) und
- mit einer zweiten Gegenklemmstelle (7a') elektrisch verbindet, wobei
die erste Gegenklemmstelle (7a) in der ersten Kontaktreihe (51) angeordnet ist und
die zweite Gegenklemmstelle (7a') in der zweiten Kontaktreihe (52) angeordnet ist und
ein eingestecktes zweites Brückenelement (20")
- die zweite Klemmstelle (72) mit einer dritten Gegenklemmstelle (7b) und
- mit einer vierten Gegenklemmstelle (7b') elektrisch verbindet, wobei
die dritte Gegenklemmstelle (7b) in der ersten Kontaktreihe (51) angeordnet ist und
die vierte Gegenklemmstelle (7b') in der zweiten Kontaktreihe (52) angeordnet ist.

8. Ein-/Ausgabebaugruppe (1) nach einem der Ansprüche 2 bis 7, wobei die Kontaktleiste (5) Öffnungen (61,62,63,64) zum Einstecken der Brückenelemente (20',20") aufweist.

9. Ein-/Ausgabebaugruppe (1) nach einem der Ansprüche 2 bis 8, wobei die Steckerleiste (6) an der Vorderseite (3) schwenkbar mit dem Basisteil (2) verbunden ist, wodurch die Steckerleiste (6) mittels einer Schwenkbewegung auf die Kontaktleiste (5) aufsetzbar ist.

10. Ein-/Ausgabebaugruppe (1) nach einem der Ansprüche 3 bis 9, wobei der erste Leiter (75) einen ersten Einspeisekontakt (75a) und der zweite Leiter (76) einen zweiten Einspeisekontakt (76a) aufweist, welche mit einer Einspeiseklemme (80) verbunden sind.

11. Ein-/Ausgabebaugruppe (1) nach einem der Ansprüche 1 bis 10, bei der die Flachbaugruppe (11,12) als eine erste Leiterplatte (11) und eine zweite Leiterplatte (12) ausgestaltet ist und die erste und/oder die zweite Leiterplatte (11,12) mehrere Funktionsmodule aufweist, wobei die Funktionsmodule über das Mittel (7) zur Weiterleitung der Versorgungsspannung jeweils mit der Versorgungsspannung versorgt werden und für jedes Funktionsmodul je zwei Klemmstellen (71,72) in dem Mittel (7) vorgesehen sind.

12. Ein-/Ausgabebaugruppe (1) nach einem der Ansprüche 1 bis 11 mit eingestecktem Brückenelement (20,20'), wobei das Brückenelement (20,20') einen ersten Schenkel (21), einen zweiten Schenkel (22) und einen dritten Schenkel (23) aufweist, und der erste und der zweite Schenkel (21,22) annähernd von gleicher Länge und gabelförmig zueinander angeordnet sind, der dritte Schenkel (23) ist an einem Gabelpunkt (24) des ersten und zweiten Schenkels (21,22) angeordnet und weist eine Länge auf, welche die Länge des ersten und zweiten Schenkels (21,22) überragt.

## Claims

1. Industrial automation technology input/output module (1), comprising
- a base section (2) with a front side (3) and a rear side (4),
- a printed circuit board (11, 12),
- a contact strip (5) disposed on the front side (3) with a plurality of contact elements (5a, 5b,...) embodied to make an electrical connection with corresponding mating contact elements (6a, 6b) of a connector strip (6),
wherein the contact elements (5a, 5b,...) are electrically connected to the printed circuit board (11, 12), **characterised in that** a means (7) of forwarding a supply voltage for a printed circuit board (11, 12) is disposed in parallel to the contact strip (5), wherein the means (7) has a terminal point (71 ,..., 74) and the connector strip (6) is embodied such that it has a plurality of mating terminal points (7a, 7b), which are electrically connected to the respective mating contact elements (6a, 6b), wherein via a link element (20) able to be inserted into the terminal point (71 ,..., 74) and into the mating terminal point (7a, 7b,...) the supply voltage is switched to the printed circuit board (11, 12).

2. Input/output module (1) according to claim 1, wherein the means (7) is surrounded by an insulating body and is disposed in the area of the front side (3) such that, for a connector strip (6) plugged into the contact strip (5) from the front side (3), the insulating body is disposed between the contact strip (5) and the connector strip (6).

3. Input/output module (1) according to claim 1 or 2, wherein the means (7) is embodied as pair of conductors extending in a longitudinal direction (100) with a first conductor (75) and a second conductor (76).

4. Input/output module (1) according to claim 3, wherein the means (7) has a first terminal point (71) and a second terminal point (72) which, in respect of the longitudinal direction (100), are disposed behind one another.

5. Input/output module (1) according to one of claims 1 to 4, wherein the contact strip (5) is embodied as a first contact strip (5') and the second contact strip (5") and in the longitudinal direction (100) the contact elements (5a, 5b,...) are disposed as a first contact row (51) of the first contact strip (5') and as a second contact row (52) of the second contact strip (5") behind one another.

6. Input/output module (1) according to one of claims 1 to 5, wherein the insulating body (8) has a first receptacle (8a) for the first terminal point (71) and a second receptacle (8b) for the second terminal point (72).

7. Input/output module (1) according to one of claims 5 to 6, wherein the terminal points arranged one behind the other (71, 72) are disposed between the first contact row (51) and the second contact row (52) such that
an inserted first link element (20')
- connects the first terminal point (71) electrically to a first mating terminal point (7a) and
- to a second mating terminal point (7a'), wherein
the first mating terminal point (7a) is disposed in the first contact row (51) and
the second mating terminal point (7a') is disposed in the second contact row (52) and
an inserted second link element (20")
- connects the second terminal point (72) electrically to a third mating terminal point (7b) and
- to a fourth mating terminal point (7b'), wherein
the third mating terminal point (7b) is disposed in the first contact row (51) and
the fourth mating terminal point in (7b') is disposed in the second contact row (52).

8. Input/output module (1) according to one of claims 2 to 7, wherein the contact strip (5) has openings (61, 62, 63, 64) for insertion of the link elements (20', 20").

9. Input/output module (1) according to one of claims 2 to 8, wherein the connector strip (6) is connected pivotably on the front side (3) to the base section (2), by which the connector strip (6) is able to be put onto the contact strip (5) by means of a pivot movement.

10. Input/output module (1) according to one of claims 3 to 9, wherein the first conductor (75) has a first feeder contact (75a) and the second conductor (76) has a second feeder contact (76a) which are connected to a feeder terminal (80).

11. Input/output module (1) according to one of claims 1 to 10, in which the printed circuit board (11, 12) is embodied as a first circuit board (11) and the second circuit board (12) and the first and/or the second circuit board (11, 12) have a number of function modules, wherein the function modules are each supplied with the supply voltage via the means (7) for forwarding the supply voltage and two terminal points (71, 72) are provided in the means in each case for each function module (7).

12. Input/output module (1) according to one of claims 1 to 11 with an inserted link element (20, 20'), wherein the link element (20, 20') has a first arm (21), a second arm (22) and a third arm (23) and the first and the second arm (21, 22) are approximately the same length and arranged in relation to one another in the shape of a fork, the third arm (23) is disposed at a fork point (24) of the first and second arm (21, 22) and has a length which projects beyond the length of the first and second arm (21, 22).

## Revendications

1. Module (1) d'entrée / sortie de la technique d'automatisation industrielle, comprenant
- une partie ( 2 ) de base ayant un côté ( 3 ) avant et un côté ( 4 ) arrière,
- un module ( 11, 12 ) plat,
- une réglette ( 5 ) de contact, qui est disposée sur le côté ( 3 ) avant et qui est conformée en ayant une multiplicité d'éléments ( 5a, 5b, ... ) de contact conformés, pour entrer en contact électrique avec des éléments ( 6a, 6b ) de contact antagoniste d'une réglette ( 6 ) de connecteur,
dans lequel les éléments ( 5a, 5b, ... ) de contact sont reliés électriquement au module ( 11, 12 ) plat,
**caractérisé en ce qu'**un moyen ( 7 ) d'acheminement d'une tension d'alimentation du module ( 11, 12 ) plat est monté parallèlement à la réglette ( 5 ) de contact, le moyen ( 7 ) ayant un point ( 71, ..., 74 ) de borne et la réglette ( 6 ) de connecteur étant conformée de manière à avoir une multiplicité de points ( 7a, 7b ) de borne antagoniste, qui sont en liaison électrique avec les éléments ( 6a, 6b ) de contact antagoniste respectifs, la tension d'alimentation étant appliquée au module ( 11, 12 ) plat par un élément ( 20 ) de pont, pouvant être enfiché dans les points ( 71, ..., 74 ) de borne et dans les points ( 7a, 7b, ... ) de borne antagoniste.

2. Module ( 1 ) d'entrée / sortie suivant la revendication 1, dans lequel le moyen ( 7 ) est entouré d'un corps isolant et est disposé dans la région du côté ( 3 ) avant, de manière à ce que, lorsque la réglette ( 6 ) de connecteur est enfilée sur la réglette ( 5 ) de contact par le côté ( 3 ) avant, le corps isolant soit disposé entre la réglette ( 5 ) de contact et la réglette ( 6 ) de connecteur.

3. Module ( 1 ) d'entrée / sortie suivant la revendication 1 ou 2, dans lequel le moyen ( 7 ) est sous la forme d'une paire de conducteurs s'étendant dans une direction ( 100 ) longitudinale et ayant un premier conducteur ( 75 ) et un deuxième conducteur ( 76 ).

4. Module ( 1 ) d'entrée / sortie suivant la revendication 3, dans lequel le moyen ( 7 ) a un premier point ( 71 ) de borne et un deuxième point ( 72 ) de borne, qui sont disposés l'un derrière l'autre par rapport à la direction ( 100 ) longitudinale.

5. Module ( 1 ) d'entrée / sortie suivant l'une des revendications 1 à 4, dans lequel la réglette ( 5 ) de contact est sous la forme d'une première réglette ( 5' ) de contact et d'une deuxième réglette ( 5" ) de contact et, dans la direction ( 100 ) longitudinale, les éléments ( 5a, 5b, ... ) de contact sont disposés successivement sous la forme d'une première rangée ( 51 ) de contacts de la première réglette ( 5' ) de contact et sous la forme d'une deuxième rangée ( 52 ) de contacts de la deuxième réglette ( 5" ) de contact.

6. Module ( 1 ) d'entrée / sortie suivant l'une des revendications 1 à 5, dans lequel le corps ( 8 ) isolant a un premier logement ( 8a ) pour le premier point ( 71 ) de borne et un deuxième logement ( 8b ) pour le deuxième point ( 72 ) de borne.

7. Module ( 1 ) d'entrée / sortie suivant l'une des revendications 5 à 6, dans lequel les points ( 71, 72 ) de borne disposés les uns derrière les autres sont disposés entre la première rangée ( 51 ) de contacts et la deuxième ( 52 ) de contacts, de manière à ce qu'un premier élément ( 20' ) de pont enfiché relie électriquement
- le premier point ( 71 ) de borne à un premier point ( 7a ) de borne antagoniste et
- à un deuxième point ( 7a' ) de borne antagoniste,
le premier point ( 7a ) de borne antagoniste étant disposé dans la première rangée ( 51 ) de contacts et
le deuxième point ( 7a' ) de borne antagoniste étant disposé dans la deuxième rangée ( 52 ) de contacts et
qu'un deuxième élément ( 20" ) de pont enfiché relie électriquement
- le deuxième point ( 72 ) de borne à un troisième point ( 7b ) de borne antagoniste et
- à un quatrième point ( 7b' ) de borne antagoniste,
le troisième point ( 7b ) de borne antagoniste étant disposé dans la première rangée ( 51 ) de contacts et
le quatrième point ( 7b' ) de borne antagoniste étant disposé dans la deuxième rangée ( 52 ) de contacts.

8. Module ( 1 ) d'entrée / sortie suivant l'une des revendications 2 à 7, dans lequel la réglette ( 5 ) de contact a des ouvertures ( 61, 62, 63, 64 ) pour l'enfichage des éléments ( 20', 20" ) de pont.

9. Module ( 1 ) d'entrée / sortie suivant l'une des revendications 2 à 8, dans lequel la réglette ( 6 ) de connecteur est reliée à la partie ( 2 ) de base de manière à pouvoir pivoter sur le côté ( 3 ) avant, de sorte que la réglette ( 6 ) de connecteur peut être mise sur la réglette ( 5 ) de contact au moyen d'un mouvement de pivotement.

10. Module ( 1 ) d'entrée / sortie suivant l'une des revendications 3 à 9, dans lequel le premier conducteur ( 75 ) a un premier contact ( 75a ) d'alimentation et le deuxième conducteur ( 76 ) un deuxième contact ( 76a ) d'alimentation, qui sont reliés à une borne ( 80 ) d'alimentation.

11. Module ( 1 ) d'entrée / sortie suivant l'une des revendications 1 à 10, dans lequel le module ( 11, 12 ) plat est sous la forme d'une première plaquette ( 11 ) à circuit imprimé et d'une deuxième plaquette ( 12 ) à circuit imprimé et la première et/ou la deuxième plaquette ( 11, 12 ) à circuit imprimé a plusieurs modules de fonction, les modules de fonction étant alimentés en la tension d'alimentation, respectivement par le moyen ( 7 ) d'acheminement de la tension d'alimentation et il est prévu, pour chaque module de fonction, respectivement deux points ( 71, 72 ) de borne dans le moyen ( 7 ).

12. Module ( 1 ) d'entrée / sortie suivant l'une des revendications 1 à 11, ayant un élément ( 20, 20' ) de pont enfiché, l'élément ( 20, 20' ) de pont ayant une première branche ( 21 ), une deuxième branche ( 22 ) et une troisième branche ( 23 ) et la première et la deuxième branches ( 21, 22 ) sont à peu près de même longueur et sont disposées en forme de fourche l'une par rapport à l'autre, la troisième branche ( 23 ) est disposée sur un point ( 24 ) de fourche de la première et de la deuxième branches ( 21, 22 ) et a une longueur, qui dépasse la longueur de la première et de la deuxième branches ( 21, 22 ).
